# EUROPÄISCHE PATENTSCHRIFT

(11) **EP 1 949 038 B1**
(45) Veröffentlichungstag und Bekanntmachung des Hinweises auf die Patenterteilung: **13.04.2016**
(21) Anmeldenummer: 06806604.2
(22) Anmeldetag: 28.10.2006
(51) Int. Cl.: G01D 5/347, H01L 27/30

(54) **OPTOELEKTRISCHE WINKELMESSEINRICHTUNG**
OPTO-ELECTRICAL ANGLE MEASURING APPARATUS
DISPOSITIF DE MESURE D'ANGLE OPTOÉLECTRONIQUE

(30) Priorität: 04.11.2005 EP 05110357
(43) Veröffentlichungstag der Anmeldung: 30.07.2008
(73) Patentinhaber: Leica Geosystems AG, 9435 Heerbrugg (CH)
(72) Erfinder: AEBISCHER, Beat, CH-9435 Heerbrugg (CH); LIPPUNER, Heinz, CH-9445 Rebstein (CH); BRAUNECKER, Bernhard, CH-9445 Rebstein (CH)
(74) Vertreter: Kaminski Harmann
(86) Internationale Anmeldenummer: PCT/EP2006/010398
(87) Internationale Veröffentlichungsnummer: WO 2007/051575

(56) Entgegenhaltungen:
- EP-A- 1 365 207
- US-A- 4 752 126
- US-A1- 2002 018 220
- SOMEYA T ET AL: "A large-area, flexible, and lightweight sheet image scanner integrated with organic field-effect transistors and organic photodiodes" ELECTRON DEVICES MEETING, 2004. IEDM TECHNICAL DIGEST. IEEE INTERNATIONAL SAN FRANCISCO, CA, USA DEC. 13-15, 2004, PISCATAWAY, NJ, USA,IEEE, 13. Dezember 2004 (2004-12-13), Seiten 365-368, XP010788788 ISBN: 0-7803-8684-1

## Beschreibung

Die Erfindung betrifft eine optoelektrische Winkelmesseinrichtung zur Bestimmung mindestens eines Winkels um mindestens eine Achse.

Das Bestimmen von Richtungen und Winkeln ist in vielen Anwendungsbereichen, wie beispielsweise in der geodätischen und industriellen Vermessung, gefordert. Entwicklungen in der Winkelmesstechnik führen über mechanische Ablesevorgänge bis zur vollautomatisierten Winkelmessung im heutigen Stand der Technik. Mit der Automatisierung sind höhere Messgenauigkeiten erzielbar, Beobachtungszeiten verkürzbar sowie Messwerte direkt abspeicherbar und in digitaler Form weiterverarbeitbar.

Bekannte Winkelmessvorrichtungen umfassen im Allgemeinen einen sogenannten Teilkreis und eine Abtasteinrichtung. Der Teilkreis ist als Codeträger ausgebildet, er weist eine Teilung oder Codierung zur Positionsbestimmung am Kreis auf. Eine zur Winkelbestimmung mit Teilung oder Codierung ausgebildete Vorrichtung wird im Folgenden als Codeträger oder als Teilkreis bezeichnet. Die Codierung ist auf einer Oberfläche - Kreis- oder Mantelfläche - des Codeträgers aufgebracht.

Zur automatischen Erfassung der Winkelwerte wird der relativ zur Abtasteinrichtung um eine Achse drehbare Codeträger mittels unterschiedlicher Techniken abgetastet. Bekannte Abtastverfahren sind elektronisch-magnetische, elektrische und optisch-elektronische Verfahren. Die folgenden Ausführungen beziehen sich auf optisch-elektronische Abtastverfahren und Abtasteinrichtungen.

Zur Bestimmung von Winkelstellungen von 0° bis 360° ist die Codierung üblicherweise in einem Vollkreis angeordnet. Die Winkelauflösung des Vollkreises bestimmt sich nach Art der Codierung und nach der zum Lesen der Codierung eingesetzten Abtasteinrichtung. So wird beispielsweise durch Aufbringen eines Codes in mehreren Spuren oder durch eine feinere Teilung die Winkelauflösung gesteigert, wobei die erreichbare Auflösung aus fertigungs- und kostentechnischen Gründen beschränkt ist. Zum Lesen des Codes sind z.B. Anordnungen von einem oder mehreren Abtastelementen am Teilkreis bekannt. CCD-Zeilen-Arrays oder CCD-Flächen-Arrays können beispielsweise solche Abtastelemente darstellen. Die US20020018220 A1 offenbart eine gattungsgemässe optische Winkelmesseinrichtung.

Nachdem derartige Abtasteinrichtungen jeweils nur einen kleinen Codebereich erfassen können, sind zum Erreichen der geforderten Messgenauigkeiten - die für geodätische Anwendungen beispielsweise im Bereich < 3 mgon liegen - verschiedene Verfahren und Vorrichtungen entwickelt worden. So ist es insbesondere üblich, eine Grobmessung mit einer Feinmessung zu kombinieren bzw. durch Interpolation und rechnerische Auswertung die geforderte Auflösung zu erreichen und Messfehler zu reduzieren. Diesbezügliche Winkelmessvorrichtungen umfassen z.B. zusätzliche Codierungen, Abtastgitter oder mehrere Abtaster zur Mehrfachabtastung. Derartige bekannte Lösungen sind jedoch technisch komplex und kostenintensiv oder stellen Kompromisse zwischen Messgenauigkeit und Messgeschwindigkeit dar.

Eine Aufgabe der Erfindung ist die Bereitstellung einer Winkelmesseinrichtung, welche eine Reduktion technischer Komplexität bei Einhaltung der gattungsgemäss erforderlichen Messgenauigkeit ermöglicht.

Diese Aufgabe wird erfindungsgemäss durch die Gegenstände des Anspruchs 1 bzw. der abhängigen Ansprüche gelöst oder die Lösungen weitergebildet.

Erfindungsgemäss wird eine Winkelmesseinrichtung mit einem Codeträger, der einen optisch erfassbaren Positionscode trägt, sowie einer Abtasteinrichtung in Form einer lichtempfindlichen Zeile oder Fläche bereitgestellt, wobei mittels der Abtasteinrichtung ein grösserer codierter Bereich des Codeträgers, im wesentlichen der gesamte codierte Bereich, simultan erfassbar ist. Damit ist einerseits die Positionsbestimmung mit einem weniger komplexen Code möglich, andererseits sind Redundanzinformationen gewinnbar, indem ein grösserer Bereich als zur eindeutigen Positionsbestimmung erforderlich erfasst wird. Durch die zusätzliche Messinformation ist eine zuverlässige Messung gewährleistet. Weiters wird mit der Erfassung eines grösseren Codebereichs - gegebenenfalls von 360° - die Messgenauigkeit gesteigert, beispielsweise durch Integration über eine grössere Anzahl von Messwerten.

Das Erfassen des codierten Bereichs wie vorgängig beschrieben erfolgt mittels der Abtasteinrichtung, die derart ausgebildet ist, dass sie entlang eines inneren oder äusseren Umfangs - welcher den Code trägt - des Codeträgers angeordnet ist, sodass die Abtastvorrichtung den Codeträger oder der Codeträger die Abtastvorrichtung im Wesentlichen vollständig umgreift. Vorteilhaft umgibt die Abtasteinrichtung den Codeträger oder der Codeträger die Abtasteinrichtung entlang wenigstens eines Umfangs vollständig. Unter einem Bereich des Codes ist im Rahmen der Erfindung auch ein einzelnes punkt- oder linienförmiges Element, wie ein Strich, zu verstehen.

Die Anordnung von Codeträger und Abtasteinrichtung ist derart, dass eine Relativ-Drehbewegung zwischen denselben ermöglicht wird. Die Drehbewegung erfolgt um wenigstens eine Achse des Codeträgers und/oder der Abtasteinrichtung. Im Allgemeinen umgeben Codeträger und Abtasteinrichtung dieselbe Achse. Der Codeträger ist z.B. um eine Achse - Drehachse - drehbar angeordnet und dreht sich mit einem Element, dessen Winkelstellung erfasst werden soll, mit, während die Abtasteinrichtung fix positioniert ist, oder aber die Abtasteinrichtung dreht sich mit, während der Codeträger fest ist.

Der Codeträger oder Teilkreis weist insbesondere eine geometrische Form mit kreisförmigem Querschnitt auf, z.B. die Form eines Zylinders oder Hohlzylinders. Ebenso kann der Codeträger als Kreissegment ausgebildet sein. Er kann aus Glas, Kunststoff oder anderem optisch transparenten Material, sowie auch aus nicht-transparentem Material mit Schlitzen und/oder Löchern gefertigt sein. Die Ausbildung aus optisch nicht durchlässigem Material ist ebenfalls möglich, wenn die optische Messung mittels am Codeträger reflektierter optischer Signale erfolgt. In einer vorteilhaften Ausführungsform der Erfindung ist ein optisch erfassbarer Positionscode auf einer - zur Achse parallele - Umfangsfläche/Mantelfläche des Codeträgers aufgebracht. Unter dem Begriff Positionscode sind optisch erfassbare Mittel zusammengefasst, wobei durch das optische Erfassen der Mittel ein positionsabhängiges Signal erzeugbar ist. Die Positionsabhängigkeit kann dabei aus der Codierung oder aus der Detektionsposition abgeleitet werden. Anhand des Signals ist in weiterer Folge - mittel- oder unmittelbar - ein absoluter oder relativer Positionswert feststellbar.

Der Positionscode kann sich aus mehreren in Umfangs- und/oder Achsrichtung beabstandeten Markierungen oder nur einer einzigen Markierung zusammensetzen. Eine auf die MantelOberfläche aufgebrachte oder in die Oberfläche eingebrachte Strichteilung als Positionscode stellt bei inkrementeller Strichteilung einen Codeträger zur Messung von Relativwerten bereit. Oftmals ist ein derartiger Codeträger mit einer Grob- und einer Feinteilung versehen. Ein zur absoluten Messwertgebung ausgebildeter Codeträger ist mit einem Absolutcode ausgeführt. Der Code kann in einer oder mehreren konzentrischen Spuren auf der Mantelfläche des Codeträgers angeordnet bzw., insbesondere mittels Photolithographie, aufgebracht sein. Ebenso kann die Mantelfläche einen sich in Umfangs- und Achsrichtung erstreckenden Code aufweisen, beispielsweise einen die Achse spiralförmig umgebenden Code.

Mit der Abtasteinrichtung und dem Codeträger der erfindungsgemässen Winkelmesseinrichtung, die relativ zueinander entlang eines, insbesonder vollen, Umfangs angeordnet sind, werden die Gestaltungsmöglichkeiten für die Codierung des Codeträgers vermehrt. So ist die Art der Codierung nach Gesichtspunkten der Komplexität, Wirtschaftlichtkeit, Präzision der Messung und/oder Fehlererkennung wählbar.

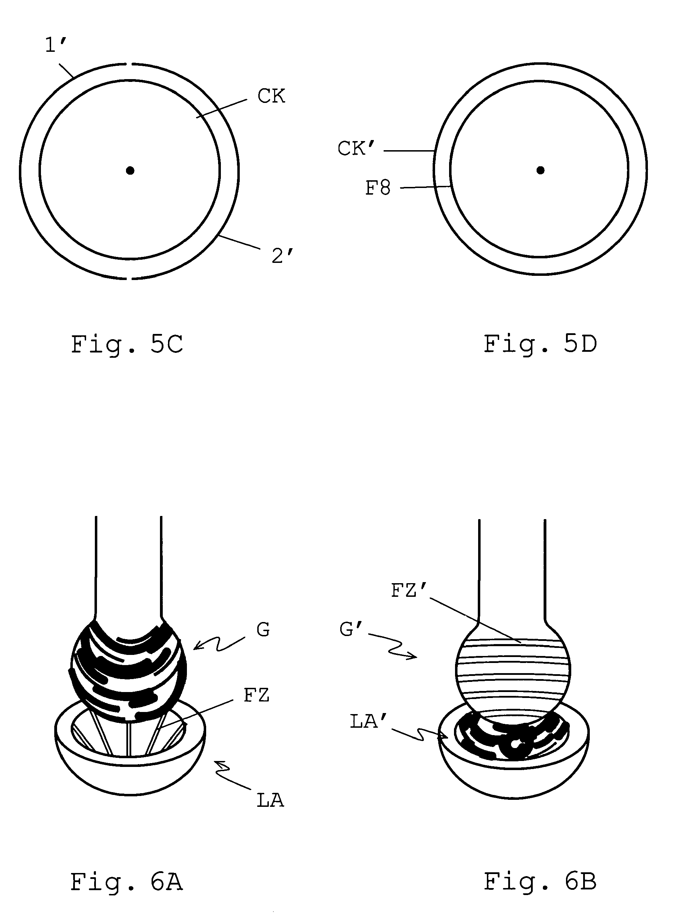

Beispielsweise kann die Winkelmesseinrichtung mit der Abtasteinrichtung, die entlang eines inneren oder äusseren codetragenden Umfangs des Codeträgers derart angeordnet ist, dass ein grösserer Winkelbereich, insbesondere 360° oder nahezu 360° - bzw. soviel Grad wie die Anordnung es zulässt (siehe z.B. Figur 6A) - des codetragenden Umfangs erfassbar ist, einen wesentlich vereinfachten Codeträger bzw. Code aufweisen. Bei einer 360°-Abtasteinrichtung kann der Code sogar auf einen Punkt oder einen Strich reduziert sein. Das Ableiten der Positionsinformation ist nach Kalibrierung der Abtasteinrichtung aus der Detektionsposition des Positionscodes auf der Abtasteinrichtung möglich, wobei der Positionscode eben als einzelnes Codeelement, wie als der Strich, oder der Codeträger selbst als Strichelement ausgeführt sein kann.

Durch die Erfassung des grösseren, insbesondere des gesamten, codetragenden Codeträgerbereichs sind Winkelmessungen mit höherer Präzision durchführbar. Bei inkrementellem Code ist weiters eine entsprechend gekennzeichnete Anfangs- und EndStellung immer feststellbar. Auch können Fehlerquellen, wie beispielsweise Kreisteilfehler, durch Abbildung der gesamten oder weitgehend gesamten Teilkreis-Codierung festgestellt und entsprechend korrigiert werden. Bei der Gesamt-Abbildung ist ausserdem eine eindeutige Codezuordnung jederzeit gewährleistet, womit - wie vorgängig erwähnt - auf Codeelemente verzichtet werden kann. Damit sind in erfindungsgemässen Winkelmesseinrichtungen Codeträger mit weniger komplexen Codes einsetzbar, was fertigungs- und kostentechnische Erleichterungen darstellt.

Der Positionscode des Codeträgers wird durch, beispielsweise von einer Beleuchtungseinrichtung bereitgestellte, optische Strahlung auf der lichtempfindlichen Abtasteinrichtung abgebildet. Die Abtasteinrichtung in Form der lichtempfindlichen Zeile weist zeilenförmig in Umfangsrichtung angeordnete lichtempfindliche Bereiche auf. Mit zeilenförmig in Umfangs- und Achsrichtung des Codeträgers, insbesondere matrixförmig, angeordneten Bereichen wird die lichtempfindliche Fläche gebildet.

Die lichtempfindlichen Bereiche stellen z.B. lichtempfindliche organische Photodioden dar. Durch die Ausbildung einer transparenten Polymer-Matrix mit einer Vielzahl der organischen Photodioden ist eine flexible transparente oder teiltransparente Abtastfolie bereitstellbar. Ist die Folie gegenüber dem Codeträger entsprechend angeordnet, so wird auf den Codeträger treffende optische Strahlung - je nach Ausführung des Codeträgers und des Codes - als reflektierte oder durchgelassene Strahlung von den lichtempfindlichen Bereichen detektiert. Beispielsweise wird reflektiertes oder transmittiertes Licht von mehreren organischen Photodioden als lichtempfindliche Bereiche empfangen und als elektrische Spannung ausgegeben. Die Spannungswerte sind in der Folge digitalisierbar und als digitale Werte weiterverarbeitbar. Da derartige Abtastfolien in Massenproduktion hergestellt werden können, ist eine äusserst kostengünstige und dennoch hochpräzise Abtasteinrichtung gegeben.

Eine als Abtasteinrichtung geeignete Abtastfolie ist beispielsweise in dem auf den Seiten 22,23 in der Ausgabe des Wissenschaftsmagazins OLE (Opto & Laser Europe) vom Februar 2005 erschienen Artikel "Pocket scanner has curved surfaces wrapped up" beschrieben, dessen Inhalt hiermit als in diese Anmeldung aufgenommen gilt. Die auch als "sheet image-scanner" oder "image-scanner film" bezeichnete Abtastfolie ist als dünne Kunststoff-Folie ausgebildet. Die Folie kann z.B. zweischichtig aus einer ersten Folie mit einem Feld lichtempfindlicher organischer Photodioden und einer zweiten Folie mit einem Feld organischer Transistoren aufgebaut sein, wobei die Folien mittels Silberpaste verbunden sind. Die Photodioden-Matrix und die Transistoren-Matrix weisen jeweils eine Vielzahl - z.B. Tausende - von Photodioden und Transistoren auf. Die Matrizen sind so übereinandergelegt, dass Sensorzellen mit je einer Photodiode und einem Transistor gebildet werden. Diese Verwendung organischer Halbleiter bietet die Möglichkeit der einfachen und grossflächigen Herstellung, beispielsweise mittels Druck- oder Aufdampftechniken, sowie ein robustes und flexibles Endprodukt. Die Abtastfolie ist auch in dem Artikel "A Large-Area, Flexible, and Lightweight Sheet Image Scanner Integrated with Organic Field-Effect Transistors and Organic Photodiodes" von T. Someya et al. publiziert in IEEE International Electron Devices Meeting Digest of Technical Papers (IEDM), Seiten 365 - 368, Dezember 2004, beschrieben, dessen Inhalt hiermit als in diese Anmeldung aufgenommen gilt.

Wie vorgängig erwähnt ist die Abtasteinrichtung gegenüber dem codierten Flächenbereich des Codeträgers derart angeordnet, dass die Abtasteinrichtung den codierten Bereich oder der codierte Bereich die Abtasteinrichtung im Wesentlichen vollständig umgreift. Unter dem Begriff umgreifen ist - bei umgreifender Abtasteinrichtung - eine Anordnung zu verstehen, bei welcher eine Umfangsfläche der Abtasteinrichtung eine Umfangsfläche des Codeträgers derart umgibt, dass die umgebene Umfangsfläche des Codeträger in den von der Umfangsfläche der Abtasteinrichtung aufgespannten Raum hineinragt und sich die beiden Umfangsflächen in berührungsfrei beabstandeter, einen Zwischenraum bildender, Gegenüberlage befinden. Das vollständige Umgreifen zweier 360°-Umfangsflächen ist im Querschnitt durch zwei konzentrische Kreise darstellbar.

Die Möglichkeiten der Anordnung von Abtasteinrichtung und Codeträger umfassen beispielsweise eine den Codeträger entlang dessen gesamten Umfangs umgreifende Abtasteinrichtung. Ebenso kann der Codeträger die Abtasteinrichtung entlang deren Umfangs umgreifen. In einer Ausführungsform der Erfindung ist die Abtasteinrichtung einstückig ausgebildet und umgreift den Codeträger entlang eines Umfangs desselben vollständig. Insbesondere umgreift die Abtasteinrichtung den Codeträger zumindest entlang eines zur Winkelmessung relevanten Umfangsbereichs. Ein vollständiges oder im Wesentlichen vollständiges Umgreifen kann auch mit einer mehrteiligen Abtasteinrichtung realisiert werden, indem die mehreren Teile aneinandergereiht oder geringstfügig beabstandet angeordnet werden, solcherart als einstückige Abtasteinrichtung wirkend. Weiters können auch mehrere Abtasteinrichtungen vorgesehen sein, die insbesondere quer zur Umfangsrichtung angeordnet sind, um z.B. grob- und feinkodierte Spuren und/oder eine von der Drehbewegung abweichenden Relativbewegung zu erfassen. In ihrer flächigen Ausdehnung parallel zur Drehachse können Codeträger und Abtasteinrichtung einander entsprechen oder sich unterscheiden. Mit einer Abtasteinrichtung, deren Ausdehnung die des Codeträgers übertrifft, sind Bewegungen in Richtung der Drehachse feststellbar.

Das optische Erfassen des Positionscodes mittels Umgebungslicht ist für eine - entsprechend viel Umgebungslicht empfangende - erfindungsgemässe optisch-elektronische Winkelmesseinrichtung mit Codeträger und Abtasteinrichtung möglich. Nachdem eine Winkelmesseinrichtung aber meist in ein Messgerät integriert ist, ist im Allgemeinen eine Beleuchtungseinrichtung vorzusehen. Diese kann mittig in einem optisch transparenten oder teiltransparenten Codeträger angeordnet sein, diesen also von innen beleuchten. Die aussen um den Umfang des Codeträgers angeordnete Abtasteinrichtung erfasst durchtretendes Licht - die Abtastung erfolgt dann mittels des sogenannten Durchlichtverfahrens. Beim Durchlichtverfahren wird der Codeträger - beispielsweise ein Glaszylinder - mit lichtdurchlässigen und lichtundurchlässigen Bereichen kodiert. Von einer Seite wird die Codierung beleuchtet, auf der anderen Seite ist die Abtasteinrichtung als Empfangseinrichtung angeordnet. Der Codeträger befindet sich also zwischen Beleuchtungseinrichtung und Empfangseinrichtung. Im Gegensatz dazu kann aber auch das sogenannte Auflichtverfahren zur Abtastung eingesetzt werden. Für das Auflichtverfahren sind Beleuchtungs- und Empfangseinrichtung auf derselben Seite des Codeträgers angeordnet. Dieser ist teilweise reflektierend ausgebildet bzw. weist unterschiedliche Reflexionseigenschaften auf, sodass unterschiedliche Strahlintensitäten registriert werden.

Ist die Abtasteinrichtung optisch transparent oder teilweise transparent, beispielsweise mit lichtdurchlässigen Bereichen zwischen den lichtempfindlichen Bereichen, so kann die Auflichttechnik auch angewendet werden, indem der Codeträger durch die zumindest teilweise transparente Abtasteinrichtung hindurch beleuchtet wird. Die Beleuchtung kann auch schräg in den Zwischenraum zwischen Codeträger und Abtasteinrichtung erfolgen. Einige Möglichkeiten der Beleuchtung bzw. der Beleuchtungsanordnung sind als Ausführungsbeispiele in den Figuren dargestellt.

Die Wahl der Beleuchtungseinrichtung - wie Laserdiode, Lichtleiter, diffuse Strahlung - trifft der Fachmann insbesondere nach fertigungs- und/oder kostentechnischen Gesichtspunkten. Auch wird die Wahl im Allgemeinen von der gewünschten Anordnung der Beleuchtungseinrichtung relativ zu Codeträger und Abtasteinrichtung abhängen.

Ein Einsatzbereich für erfindungsgemässe Winkelmesseinrichtungen sind geodätische Messinstrumente mit der Funktion der Richtungs- und Winkelbestimmung. So sind beispielsweise Theodoliten mit horizontalem und vertikalem Teilkreis und entsprechenden Ableseeinrichtungen ausgestattet, um Horizontal- und Vertikalwinkel mit höchster Genauigkeit messen zu können.

Die erfindungsgemässe Winkelmesseinrichtung wird nachfolgend anhand von in den Zeichnungen schematisch dargestellten Ausführungsbeispielen rein beispielhaft näher beschrieben. Im Einzelnen zeigen
- Fig. 1A: eine erste Winkelmesseinrichtung nach dem Stand der Technik mit vier Abtasteinheiten;
- Fig. 1B: eine zweite Winkelmesseinrichtung nach dem Stand der Technik mit fünf Lumineszenz- und Photodioden;
- Fig. 2: eine Ausführungsform eines Codeträgers für eine erfindungsgemässe Winkelmesseinrichtung;
- Fig. 3A-3J: Ausführungsformen erfindungsgemässer Winkelmesseinrichtungen mit alternativen Anordnungen und Ausbildungen von Codeträger und Abtasteinrichtung;
- Fig. 4A-4D: in vier Teilfiguren mögliche Anordnungen von Beleuchtungseinrichtungen erfindungsgemässer Winkelmesseinrichtungen;
- Fig. 5a-5D: in vier Teilfiguren schematisch mögliche Anordnungen von Codeträger und Abtasteinrichtung;
- Fig. 6A: ein erstes Ausführungsbeispiel einer erfindungsgemässen Winkelmesseinrichtung zur Messung der Winkellage eines Kugelgelenks;
- Fig. 6B: ein zweites Ausführungsbeispiel einer erfindungsgemässen Winkelmesseinrichtung zur Messung der Winkellage eines Kugelgelenks.

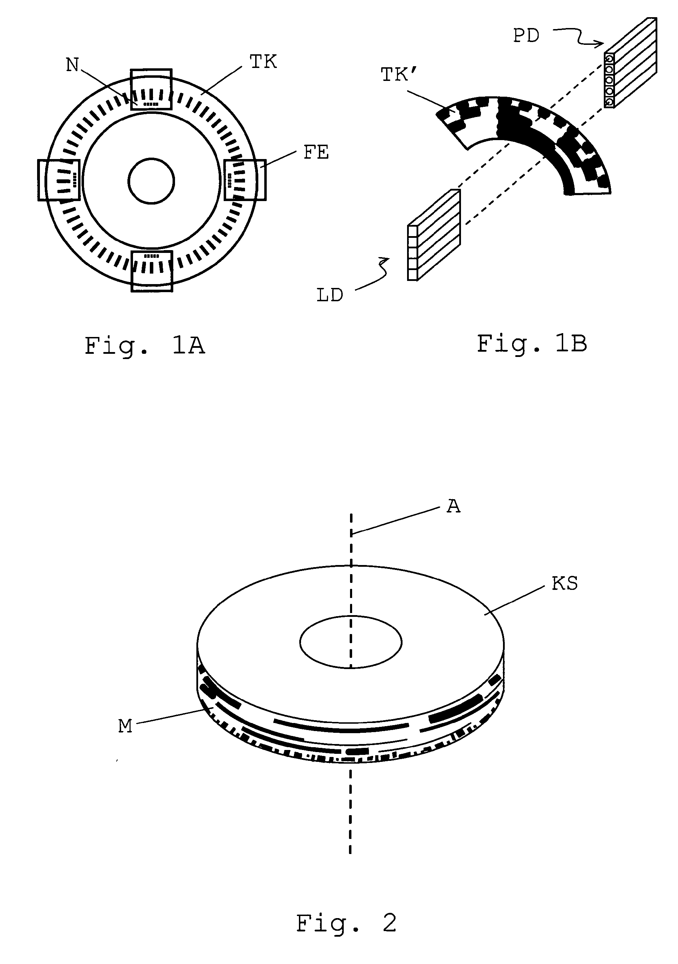

Figur 1A zeigt eine Anordnung zum Einstellen von Winkellagen nach dem Stand der Technik. Die Anordnung weist einen - eine inkrementale Strichteilung aufweisenden - Teilkreis TK mit vier Nullmarkierungen N und vier Abtasteinheiten auf. Die zwei Paar einander diametral gegenüberliegenden Photoelemente FE als Abtasteinheiten sowie die zwei Paar einander gegenüberliegenden Nullmarkierungen N sind zum Einstellen genauerer Winkellagen vorgesehen, insbesondere zur Vermeidung von zyklischen, periodischen Fehlern.

Eine weitere optisch-elektronische Winkelmess-Anordnung nach dem Stand der Technik ist in Figur 1B dargestellt. Die Winkelmess-Anordnung ist zur groben Absolutwinkelmessung ausgebildet. Dazu ist ein Teilkreis TK' mit fünf konzentrischen Codespuren ausgeführt. Zum Abtasten der Spuren sind fünf Lumineszenzdioden LD sowie fünf Photodioden PD senkrecht zur Umfangsrichtung an einander gegenüberliegenden Kreisseiten als Lichtschranken angeordnet. Je nach Lichtdurchlässigkeit bzw. Lichtundurchlässigkeit der jeweiligen Codespur wird ein Signal (hell/dunkel) und daraus ein Binärzeichen (1/0) erzeugt.

Figur 2 stellt eine Ausführungsform eines in einer erfindungsgemässen Winkelmesseinrichtung einsetzbaren Codeträgers dar. Der Codeträger ist als um eine Achse A drehbare Kreisscheibe KS ausgebildet, wobei der Code entlang der Umfangsfläche - Mantelfläche M - der Kreisscheibe KS aufgebracht ist. Die Darstellung des Codes ist - auch im Folgenden - rein beispielhaft.

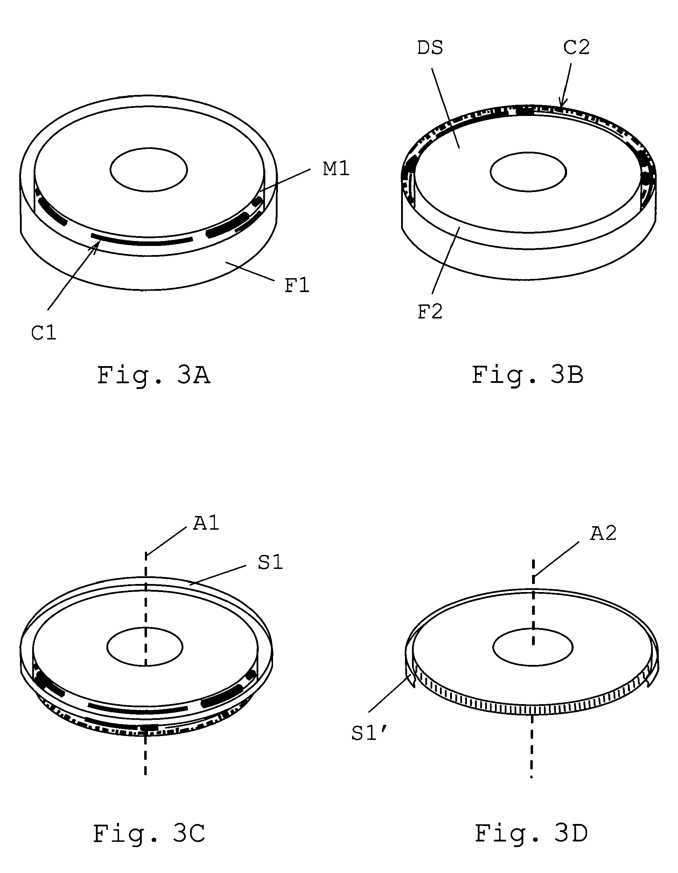

Die Figuren 3A-3J zeigen erfindungsgemässe Winkelmesseinrichtungen mit unterschiedlichen Ausbildungen und Anordnungen von Codeträger und Abtasteinrichtung und werden zusammenhängend beschrieben.

In Figur 3A ist der Codeträger scheibenförmig mit auf der Umfangsfläche/Mantelfläche M1 aufgebrachtem Positionscode C1 ausgebildet. Eine lichtempfindliche, flächige Abtastfolie F1 als Abtasteinrichtung umgreift den Codeträger entlang dessen gesamten Umfangs. Figur 3B zeigt einen Codeträger, welcher die als lichtempfindliche Fläche ausgebildete Abtastfolie F2 entlang deren gesamten Umfangs umgreift - die Abtastfolie F2 ist entlang des inneren Umfangs des Codeträgers angeordnet, wobei die Abtastfolie hier auf der Umfangfläche/Mantelfläche einer Drehscheibe DS befestigt ist. Die Drehscheibe DS kann gegebenenfalls weitere Elektronik, wie Speicher- und/oder Auswerteelektronik, umfassen. Der Codeträger trägt den Positionscode C2 entsprechend entlang seines inneren Umfangs. Codeträger und Abtastfolie F1 und F2 in den Figuren 3A und 3B sind jeweils konzentrisch so angeordnet, dass die Umfangsfläche des Codeträgers in dem von der Umfangsfläche der Abtastfolie F1 aufgespannten Raum (Fig. 3A) liegt oder die Umfangsfläche der Abtastfolie F2 in dem von der Umfangsfläche des Codeträgers aufgespannten Raum liegt (Fig. 3B), wobei Codeträger und Abtastfolie F1 und F2 durch einen Zwischenraum beabstandet sind. Die Abtastfolien F1 und F2 sind jeweils einstückig ausgebildet und weisen eine Vielzahl - nicht dargestellter - organischer, matrixartig angeordneter Photodetektoren auf, das Codeträger-Material ist hier Kunststoff.

In den Figuren 3C bis 3E ist eine lichtempfindliche Bereiche aufweisende Kunststoff-Folie um einen Codeträger angeordnet, wobei Kunststoff-Folie und Codeträger jeweils um eine Achse A1 bwz. A2 bwz. A3 angeordnet sind. Die Kunststoff-Folie S1 in Form einer lichtempfindlichen Zeile aus Figur 3C ist um den gesamten Umfang des Codeträgers angeordnet und weist eine geringere Ausdehnung in Achsrichtung auf als der Codeträger.

Der in Figur 3D dargestellte Codeträger hingegen ist ebenfalls als Zeile ausgeführt und wird von der zeilenförmigen, mit einer Vielzahl lichtempfindlicher Sensorzellen mit organischen Photodioden und organischen Transistoren ausgebildeten Abtasteinrichtung S1' entlang seines gesamten Umfangs umgriffen. Eine derartige Ausführungsform stellt eine Anordnung mit sehr geringen axialen Abmessungen bereit. Auf den Codeträger ist hier eine Strichteilung als Inkrementalcode aufgebracht.

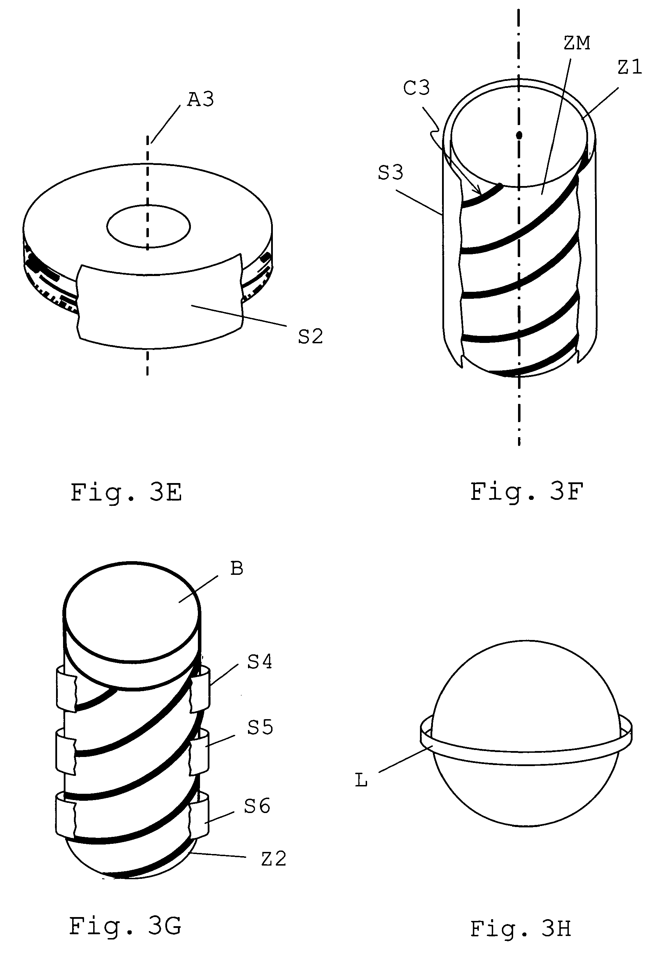

Die Ausdehnung der flächigen Folie S2 aus Figur 3E in Achsrichtung ist grösser als die des Codeträgers. Mit dieser Ausführungsform sind - unerwünschte - Bewegungen des Codeträgers in Richtung der Achse A3 besonders gut detektierbar.

In allen Figuren 3C, 3D und 3E umgreift also die Abtasteinrichtung den Codeträger, sodass der Codeträger in dem von der Umfangsfläche der Abtasteinrichtung aufgespannten Raum liegt. Der von der Umfangsfläche aufgespannte Raum ist der von der Umfangsfläche eingeschlossene Raum, welcher Raum auch die Achse A1 bzw. A2 bzw. A3 des Codeträgers bzw. der Abtasteinrichtung einschliesst. So kann die erfindungsgemässe Winkelmesseinrichtung je nach gewünschter/bevorzugter Eigenschaft - z.B. Messgenauigkeit, Kompaktheit der Anordnung, Kosten und Komplexität der Herstellung - ausgebildet und angeordnet sein.

Auch die Figuren 3F bis 3J zeigen weitere Ausführungsformen von Codeträger und Abtasteinrichtung, wobei die Abtasteinrichtung den Codeträger entlang wenigstens eines Umfangs vollständig umfgreift.

In Figur 3F ist der Codeträger als zylindrischer Drehkörper Z1 ausgebildet, der auf der Zylinder-Mantelfläche ZM einen spiralförmigen Code C3 als Positionscode trägt. Eine Detektionsfolie S3 als Abtasteinrichtung umgreift den Drehkörper Z1 entlang dessen gesamter Höhe und entlang dessen gesamten Umfangs.

In Figur 3G sind drei Abtasteinrichtungen um einen Hohlzylinder-Codeträger Z2 angeordnet. Die Abtasteinrichtungen sind als Folien S4, S5 und S6 ausgeführt, wobei jede der Folien S4, S5 und S6 ein Feld organischer Photodioden und ein koinzidierendes Feld organischer Transistoren aufweist. Die Folien S4, S5 und S6 umgreifen den Hohlzylinder-Codeträger Z2 entlang dessen Umfangs vollständig und sind quer zur Umfangsrichtung beabstandet zueinander angeordnet. Weiters ist ein Beleuchtungselement B dargestellt. Das Beleuchtungselement B weist eine aufgeraute, optisch transparente Grundplatte auf, sodass Licht einer Lichtquelle der Beleuchtungseinrichtung B durch die als Diffusor wirkende Grundplatte diffus ins Innere des Hohlzylinders gestreut wird. So wird der Codeträger von innen homogen beleuchtet und mittels des Durchlichtverfahrens anhand der Folien S4, S5 und S6 abgetastet. Im Vergleich zu den vorherigen Ausführungsformen weisen die Ausführungsformen von Codeträger und Abtasteinrichtung der Figuren 3F und 3G einen geringeren Durchmesser und eine grössere Erstreckung in Achsrichtung auf. Für eine solche Ausbildung einer erfindungsgemässen Winkelmesseinrichtung sind gegebenenfalls auch längliche Beleuchtungseinrichtungen, beispielsweise Glasfaser-Lichtleiter, einsetzbar.

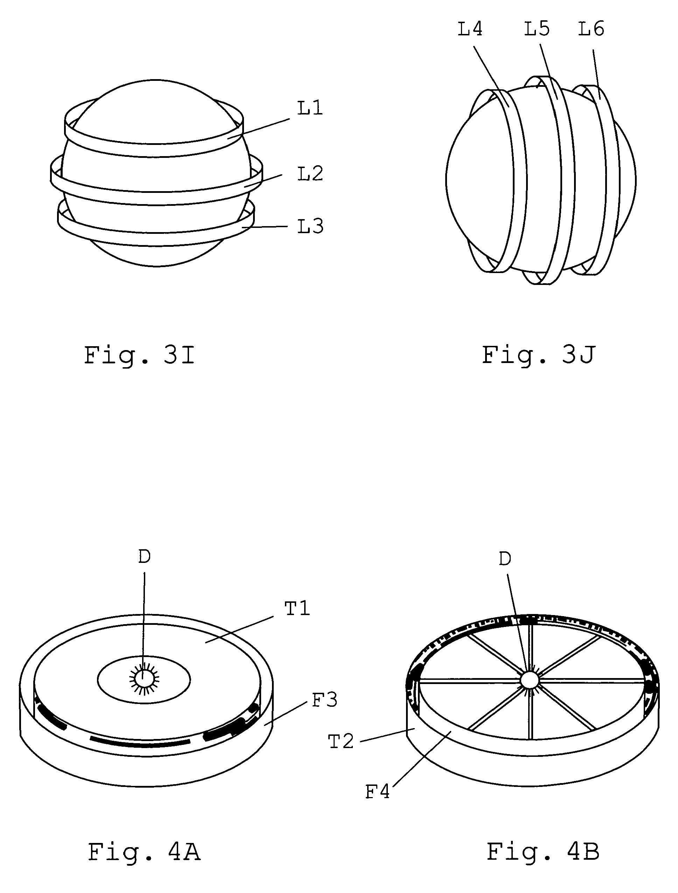

Die Figuren 3H, 3I und 3J zeigen kugelförmige Codeträger mit Abtasteinrichtungen in Form lichtempfindlicher Zeilen. Der auf dem jeweiligen Codeträger aufgebrachte Code ist nicht dargestellt. Auch eine Lagerung der jeweiligen Codeträger ist nicht gezeigt - die Codeträger sind z.B. als Kugelgelenke gelagert. Die Abtastzeile L aus Figur 3H umgibt den Codeträger entlang eines Umfangs vollständig. In Figur 3I sind eine erste Abtastzeile L1 um einen ersten Umfang, eine zweite Abtastzeile L2 um einen zweiten Umfang und eine dritte Abtastzeile L3 um einen dritten Umfang des Codeträgers angeordnet. Die Figur 3J zeigt ebenfalls drei Abtastzeilen L4, L5 und L6, die den Codeträger jeweils entlang eines Umfangs umgreifen und quer zu den Umfangsrichtungen voneinander beabstandet angeordnet sind.

In den Figuren 4A bis 4D sind Beleuchtungseinrichtungen für eine erfindungsgemässe Winkelmesseinrichtung in mehreren Varianten der Anordnung dargestellt. Die Beleuchtungseinrichtungen sind rein beispielhaft als Leuchtdioden dargestellt - es versteht sich, dass unterschiedlichste Strahlungsquellen einsetzbar sind, sowie auch die Beleuchtungseinrichtungen unterschiedlichst ausbildbar sind und beispielsweise weitere optische Elemente, wie Linsen oder Diffusoren, umfassen können.

Der Teilkreis T1 aus Figur 4A ist von innen her beleuchtet. Das Material des Teilkreises T1 ist hier Glas. Zum Schutz des Codes kann der Glaskreis mit einer Schutzschicht überzogen sein bzw. ein Schutzglas aufgeklebt sein. Durch die mittig innerhalb des Kreises angeordnete Leuchtdiode D wird der Kreis gleichmässig ausgeleuchtet. Licht tritt von innen durch den Kreis nach aussen in Richtung der lichtempfindlichen Abtastfolie F3, welche die durch den Code beeinflussten Lichtsignale empfängt. Eine alternative Beleuchtungsform für eine derartige Anordnung ist mit einem selbstleuchtenden Code, welcher beispielsweise organische Leuchtdioden aufweist, realisierbar.

In Figur 4B umgibt der Teilkreis T2 konzentrisch die innere Abstastfolie F4. Wiederum erfolgt die Beleuchtung von der Mitte der Anordnung aus. Die Abtastfolie F4 weist zwischen lichtundurchlässigen lichtempfindlichen Sensorelementen lichtdurchlässige Bereiche auf, sodass Licht der mittig positionierten Leuchtdiode D durch die Folie auf die Mantelfläche des Teilkreises T2 trifft und dort reflektiert wird. Die lichtempfindlichen Bereiche - Sensorelemente - der Folie empfangen die reflektierte Strahlung als positionsabhängiges Abtastsignal.

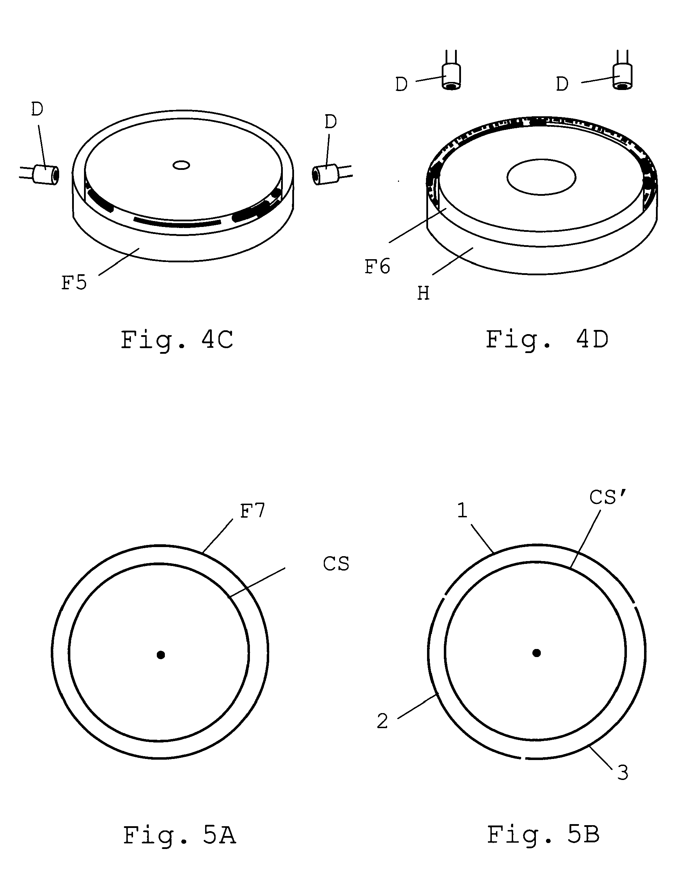

Figur 4C zeigt eine Darstellung mit einer äusseren Beleuchtung. Zwei Leuchtdioden D sind entlang der Umfangsfläche der Messeinrichtung positioniert und beleuchteten den Code durch die Folie F5, welche wiederum optisch teildurchlässig ausgebildet ist und die von der Codestruktur reflektierten Signale empfängt.

Die Beleuchtungseinrichtung aus Figur 4D umfasst zwei Leuchtdioden D, welche zur Beleuchtung von Hohlkreis-Codeträger H und Folie F6 schräg in den Zwischenraum derselben abstrahlen. Diese Art der Beleuchtung entspricht wiederum der Technik des Auflichtverfahrens - die schräg einfallende Strahlung wird am - codierten - inneren Umfang des Hohlkreises zur Folie F6 reflektiert.

Es versteht sich, dass als Beleuchtungseinrichtung in den Ausführungsbeispielen der Figuren 4C und 4D genauso eine einzige Leuchtquelle oder aber mehrere Leuchtquellen eingesetzt werden können.

In den Figuren 5A bis 5D sind rein schematisch vier Ausführungsbeispiele für mögliche Anordnungen von Codeträger und Abtasteinrichtung einer erfindungsgemässen Winkelmesseinrichtung dargestellt. Selbstverständlich ist eine Vielzahl weiterer alternativer Anordnungen möglich.

Figur 5A zeigt eine die Codeträger-Scheibe CS vollständig umgebende einstückige Abtasteinrichtung F7. In Figur 5B ist die Abtasteinrichtung dreiteilig ausgebildet und um die Codescheibe CS' derart angeordnet, dass jedes der drei Teile 1,2 und 3 die Codescheibe CS' entlang eines Teilumfangs derselben in jeweils einem Umgreifwinkel umgreift, wobei der Gesamt-Umgreifwinkel nahezu 360° beträgt, sodass die Codescheibe CS' entlang ihres Umfangs im Wesentlichen vollständig umgriffen wird. Figur 5C zeigt eine Abtasteinrichtung aus zwei Teilen 1' und 2', die den zylindrischen Codekörper CK jeweils halbseitig umgreifen, sodass der Codekörper CK von der Abtasteinrichtung im Wesentlichen vollständig umgriffen wird. Der jeweilige Umgreifwinkel der Teile 1' und 2' beträgt hier nahezu 180°. Die Teile könnten auch jeweils genau 180° umgreifen, sodass die Abtasteinrichtung zwar zweiteilig ist, aber als einstückige Abtasteinrichtung, die den Codeträger entlang eines Umfangs vollständig umgreift, wirkt. In Figur 5D ist eine alternative Anordnung mit Hohlzylinder-Codekörper CK', welcher die - innere - Abtasteinrichtung F8 vollständig umgreift, dargestellt. Das vollständige Umgreifen erhöht die Auflösung der Messung, indem über den gesamten Code integriert werden kann.

Die Figuren 6A und 6B zeigen zwei Ausführungsbeispiele einer erfindungsgemässen Winkelmesseinrichtung, mittels welcher Ausführungen die Winkellage eines Kugelgelenks in einer entsprechenden Lagerung feststellbar ist. In Figur 6A ist das Kugelgelenk G als Codeträger ausgebildet und das Lager LA mit Folienzeilen FZ, die das Kugelgelenk jeweils entlang eines Umfangs weitgehend umgreifen, als Abtasteinrichtung. In Figur 6B ist das Lager LA' der Codeträger und das - mit Folienzeilen FZ' umgebene - Gelenk G' die Abtasteinrichtung. Die jeweiligen Folienzeilen können natürlich ebenso entlang eines alternativen oder weiteren Umfangs - z.B. quer zur jeweils gezeigten Richtung - angeordnet sein.

Die Ausführung eines Kugelgelenks mit abtastenden Folienelementen kann auch mit einem nutenartige Vertiefungen aufweisenden Kugelgelenk erfolgen, indem Folienelemente in die Vertiefungen eingebracht werden. Ebenso können Codeelemente tiefenversetzt angeordnet werden. Die Ausführung des Lagers mit Folien- oder Codeelementen kann in analoger Art und Weise erfolgen. Mit derartigen Ausführungsformen ist eine Lagerreibung der Folien- und Codeelemente vermeidbar.

## Patentansprüche

1. Optoelektrische Winkelmesseinrichtung zur Bestimmung mindestens eines Winkels um mindestens eine Achse (A, A1, A2, A3), mit
• einem die Achse (A, A1, A2, A3) umgebenden Codeträger, der einen optisch erfassbaren Positionscode (C1, C2, C3) trägt, und
• wenigstens einer Abtasteinrichtung in Form einer lichtempfindlichen Zeile oder Fläche, mit welcher Abtasteinrichtung der Positionscode (C1, C2,C3) erfassbar und ein positionsabhängiges Abtastsignal, das mit dem Winkel zwischen dem Codeträger und der Abtasteinrichtung verknüpft ist, erzeugbar ist, insbesondere wobei die Abtasteinrichtung einstückig ausgebildet ist,
**dadurch gekennzeichnet, dass**
• die Abtasteinrichtung den Codeträger entlang wenigstens eines Umfangs desselben im Wesentlichen vollständig umgreift oder
der Codeträger die Aotasteinrichtung entlang wenigstens eines Umfangs derselben im Wesentlichen vollständig umgreift.

2. Optoelektrische Winkelmesseinrichtung nach Anspruch 1,
**dadurch gekennzeichnet, dass**
die Abtasteinrichtung eine Vielzahl organischer Photodetektoren, beispielsweise Photodioden oder Photozellen, aufweist.

3. Optoelektrische Winkelmesseinrichtung nach Anspruch 2, **dadurch gekennzeichnet, dass** die Abtasteinrichtung ein Feld der organischen Photodioden und ein koinzidierendes Feld organischer Transistoren aufweist.

4. Optoelektrische Winkelmesseinrichtung nach einem der Ansprüche 1 bis 3, **dadurch gekennzeichnet, dass** die Abtasteinrichtung als flexible Abtastfolie (F1, F2) ausgebildet ist.

5. Optoelektrische Winkelmesseinrichtung nach einem der vorangehenden Ansprüche, **dadurch gekennzeichnet, dass** mehrere, insbesondere quer zur Umfangsrichtung voneinander beabstandet angeordnete, Abtasteinrichtungen vorgesehen sind.

6. Optoelektrische Winkelmesseinrichtung nach einem der vorangehenden Ansprüche, **dadurch gekennzeichnet, dass** der Positionscode (C1, C2, C3) auf einer Mantelfläche (M, M1) des Codeträgers aufgebracht ist.

7. Optoelektrische Winkelmesseinrichtung nach einem der vorangehenden Ansprüche, **dadurch gekennzeichnet, dass** der Positionscode als inkrementeller oder absoluter Code ausgeführt ist.

8. Optoelektrische Winkelmesseinrichtung nach einem der vorangehenden Ansprüche, **dadurch gekennzeichnet, dass** der Positionscode als spiralförmiger Code (C3), der die Achse umschliesst und sich entlang der Achse erstreckt, ausgeführt ist.

9. Optoelektrische Winkelmesseinrichtung nach einem der vorangehenden Ansprüche,
**gekennzeichnet durch**
eine optische Beleuchtungseinrichtung zur mittel- und/oder unmittelbaren Beleuchtung des Codeträgers.

10. Optoelektrische Winkelmesseinrichtung nach Anspruch 9, **dadurch gekennzeichnet, dass**
die Beleuchtungseinrichtung eine oder mehrere Leuchtquellen, beispielsweise Leuchtdioden (D), aufweist.

11. Optoelektrische Winkelmesseinrichtung nach Anspruch 9 oder 10, **dadurch gekennzeichnet, dass**
die Beleuchtungseinrichtung so angeordnet ist, dass der Codeträger
- von innen oder
- von aussen
beleuchtbar ist.

12. Optoelektrische Winkelmesseinrichtung nach einem der Ansprüche 1 bis 8, **dadurch gekennzeichnet, dass** der Positionscode als selbstleuchtender Code ausgeführt ist.

13. Optoelektrische Winkelmesseinrichtung nach Anspruch 12, **dadurch gekennzeichnet, dass**
der Positionscode eine Vielzahl organischer Leuchtdioden aufweist.

14. Verwendung einer optoelektrischen Winkelmesseinrichtung nach einem der Ansprüche 1 bis 13 in einem geodätischen Messinstrument.

15. Verwendung einer Abtastfolie, welche Abtastfolie als Kunststoff-Folie ausgebildet ist und ein Feld organischer Photodetektoren und ein koinzidierendes Feld organischer Transistoren aufweist, als Abtasteinrichtung in einer optoelektrischen Winkelmesseinrichtung nach einem der Ansprüche 1 bis 13.

## Claims

1. Optoelectric angle-measuring device for determining at least one angle around at least one axis (A, A1, A2, A3), comprising
• a code carrier which surrounds the axis (A, A1, A2, A3) and carries an optically detectable position code (C1, C2, C3), and
• at least one scanning device in the form of a light-sensitive line or area,
by means of which scanning device the position code (C1, C2, C3) can be detected and a position-dependent scanning signal, which is linked to the angle between the code carrier and the scanning device, can be produced, in particular wherein the scanning device is formed in one piece,
**characterized in that**
• the scanning device substantially completely surrounds the code carrier along at least one circumference thereof or
the code carrier substantially completely surrounds the scanning device along at least one circumference thereof and

2. Optoelectric angle-measuring device according to Claim 1, **characterized in that** the scanning device has a multiplicity of organic photodetectors, for example photodiodes or photocells.

3. Optoelectric angle-measuring device according to Claim 2, **characterized in that** the scanning device has a field of organic photodiodes and a coinciding field of organic transistors.

4. Optoelectric angle-measuring device according to any of Claims 1 to 3, **characterized in that** the scanning device is in the form of a flexible scanning film (F1, F2).

5. Optoelectric angle-measuring device according to any of the preceding claims, **characterized in that** a plurality of scanning devices, in particular arranged a distance apart transversely to the circumferential direction, are provided.

6. Optoelectric angle-measuring device according to any of the preceding claims, **characterized in that** the position code (C1, C2, C3) is applied to a lateral area (M, M1) of the code carrier.

7. Optoelectric angle-measuring device according to any of the preceding claims, **characterized in that** the position code is in the form of an incremental or absolute code.

8. Optoelectric angle-measuring device according to any of the preceding claims, **characterized in that** the position code is in the form of a spiral code (C3) which encloses the axis and extends along the axis.

9. Optoelectric angle-measuring device according to any of the preceding claims, **characterized by** an optical illumination device for indirect and/or direct illumination of the code carrier.

10. Optoelectric angle-measuring device according to Claim 9, **characterized in that** the illumination device has one or more light sources, for example light emitting diodes (D).

11. Optoelectric angle-measuring device according to Claim 9 or 10, **characterized in that** the illumination device is arranged so that the code carrier can be illuminated
- from the inside or
- from the outside.

12. Optoelectric angle-measuring device according to any of Claims 1 to 8, **characterized in that** the position code is in the form of a self-illuminating code.

13. Optoelectric angle-measuring device according to Claim 12, **characterized in that** the position code has a multiplicity of organic light emitting diodes.

14. Use of an optoelectric angle-measuring device according to any of Claims 1 to 13 in a geodetic measuring instrument.

15. Use of a scanning film, which scanning film is in the form of a plastic film and has a field of organic photodetectors and a coinciding field of organic transistors, as a scanning device in an optoelectric angle-measuring device according to any one of claims 1 to 13.

## Revendications

1. Dispositif optoélectrique de mesure d'angle pour déterminer au moins un angle autour d'au moins un axe (A, A1, A2, A3) avec
• un support de code qui entoure l'axe (A, A1, A2, A3) qui porte un code de position (C1, C2, C3) pouvant être détecté de manière optique et
• au moins un dispositif de balayage sous forme de ligne ou de surface sensible à la lumière, dispositif de balayage avec lequel le code de position (C1, C2, C3) peut être détecté et un signal de balayage, qui est associé à l'angle entre le support de code et le dispositif de balayage, peut être produit, en particulier cependant que le dispositif de balayage est configuré en une pièce,
**caractérisé en ce que**
• le dispositif de balayage enveloppe substantiellement entièrement le support de code le long d'au moins une circonférence de celui-ci ou
le support de code enveloppe substantiellement entièrement le dispositif de balayage le long d'au moins une circonférence de celui-ci.

2. Dispositif optoélectrique de mesure d'angle selon la revendication 1, **caractérisé en ce que** le dispositif de balayage présente une multitude de photodétecteurs organiques, par exemple de photodiodes ou de cellules photoélectriques.

3. Dispositif optoélectrique de mesure d'angle selon la revendication 1, **caractérisé en ce que** le dispositif de balayage présente un champ de photodiodes organiques et un champ de transistors organiques qui coïncide.

4. Dispositif optoélectrique de mesure d'angle selon l'une des revendications 1 à 3, **caractérisé en ce que** le dispositif de balayage est configuré comme une feuille de balayage flexible (F1, F2).

5. Dispositif optoélectrique de mesure d'angle selon l'une des revendications précédentes, **caractérisé en ce que** plusieurs dispositifs de balayages sont prévus, en particulier des dispositifs de balayage placés espacés dans le sens transversal par rapport au sens de la circonférence.

6. Dispositif optoélectrique de mesure d'angle selon l'une des revendications précédentes, **caractérisé en ce que** le code de position (C1, C2, C3) est appliqué sur une surface d'enveloppe (M, M1) du support de code.

7. Dispositif optoélectrique de mesure d'angle selon l'une des revendications précédentes, **caractérisé en ce que** le code de position est réalisé comme un code incrémentiel ou absolu.

8. Dispositif optoélectrique de mesure d'angle selon l'une des revendications précédentes, **caractérisé en ce que** le code de position est réalisé comme un code en forme de spirale (C3) qui entoure l'axe et qui s'étend le long de l'axe.

9. Dispositif optoélectrique de mesure d'angle selon l'une des revendications précédentes, **caractérisé par** un dispositif optique d'éclairage pour l'éclairage indirect et/ou direct du support de code.

10. Dispositif optoélectrique de mesure d'angle selon la revendication 9, **caractérisé en ce que** le dispositif d'éclairage présente une ou plusieurs sources de lumière, par exemple des diodes électroluminescentes (D).

11. Dispositif optoélectrique de mesure d'angle selon la revendication 9, **caractérisé en ce que** le dispositif d'éclairage est placé de telle manière que le support de code peut être éclairé
- de l'intérieur ou
- de l'extérieur.

12. Dispositif optoélectrique de mesure d'angle selon l'une des revendications 1 à 3, **caractérisé en ce que** le code de position est réalisé comme un code autoéclairant.

13. Dispositif optoélectrique de mesure d'angle selon la revendication 12, **caractérisé en ce que** le code de position présente une multitude de diodes électroluminescentes organiques.

14. Utilisation d'un dispositif optoélectrique de mesure d'angle selon l'une des revendications 1 à 13 dans un instrument de mesure géodésique.

15. Utilisation d'une feuille de balayage, laquelle feuille de balayage est configurée comme une feuille de matière plastique et présente un champ de photodiodes organiques et un champ de transistors organiques qui coïncide comme dispositif de balayage dans un dispositif optoélectrique de mesure d'angle selon l'une des revendications 1 à 13.
